# EUROPÄISCHE PATENTANMELDUNG

(11) **EP 2 104 046 A1**
(43) Veröffentlichungstag der Anmeldung: **23.09.2009**
(21) Anmeldenummer: 08004926.5
(22) Anmeldetag: 17.03.2008
(51) Int. Cl.: G06F 17/50

(54) **Verfahren und Vorrichtung zur rechnergestützten Überprüfung der Baubarkeit eines Produkts**

(71) Anmelder: VOLKSWAGEN AG, 38436 Wolfsburg (DE)
(72) Erfinder: Siggelkow, Martin, 38550 Isenbüttel (DE); Austermann, Jens, 38108 Braunschweig (DE); Bechtel, Michael, 38176 Wendeburg (DE); Stefanus, Sven, 10243 Berlin (DE)
(74) Vertreter: Banzer, Hans-Jörg

(57) **Zusammenfassung**

Verfahren und entsprechend ausgestaltete Vorrichtung zur rechnergestützten Überprüfung der Baubarkeit eines Produkts, wobei ein digitales räumliches Referenzmodell (8) zur Nachbildung eines Bauraums des Produkts, in dem ein geometrischer Körper (C), beispielsweise ein Bauteil, zur Konstruktion des Produkts angeordnet werden soll, verwendet wird. Das Referenzmodell ist in eine Vielzahl von einzeln identifizierbaren räumlichen Einheiten (9) unterteilt, wobei die Baubarkeit des Produkts durch rechnergestütztes Vergleichen des geometrischen Körpers (C) mit den einzelnen räumlichen Einheiten (9) des Referenzmodells (8) überprüft wird.

## Beschreibung

Die vorliegende Erfindung betrifft ein Verfahren sowie eine entsprechend ausgestaltete Vorrichtung zur rechnergestützten Überprüfung der Baubarkeit eines Produkts, wobei die Erfindung beispielsweise in der Kraftfahrzeugindustrie im Rahmen der rechnergestützten Konstruktion von Kraftfahrzeugen eingesetzt werden kann.

Die Entwicklung komplex aufgebauter Produkte, wie beispielsweise eines Kraftfahrzeugs, ist sehr langwierig und kostspielig. Ein wesentliches Problem bei der Entwicklung derartiger Produkte besteht darin, dass sie aus einer Vielzahl von unterschiedlichen Bauteilen oder allgemein geometrischen Körpern aufgebaut sind, die in der Regel an unterschiedlichen Stellen konstruiert werden, wobei möglichst frühzeitig im Entwicklung- oder Konstruktionsprozess festgestellt werden muss, ob die entwickelten Bauteile tatsächlich wie geplant in den dafür vorgesehenen Bauraum des Gesamtprodukts passen und nicht mit anderen Bauteilen oder sonstigen Rahmenbedingungen des Gesamtprodukts kollidieren.

Die rechnergestützte Entwicklung von komplex aufgebauten Produkten erfolgt in der Regel auf Grundlage der CAD-Technologie ("Computer Aided Design"). Im Entwicklungsprozess werden die einzelnen Bauteile oder Bauteilgruppen in Übereinstimmung mit bestimmten Vorgaben an ihre Funktion und ihr Design rechnergestützt konstruiert, wobei für jedes Bauteil ein entsprechender CAD-Datensatz generiert wird. Durch Verwendung der sogenannten DMU-Technik ("Digital Mock Up") werden diese CAD-Datensätze der einzelnen Bauteile in ein digitales Abbild, ein sogenanntes "Digital Mock Up", des Gesamtprodukts umgesetzt, d.h. alle auf CAD-Systemen konstruierten Bauteile werden miteinander zu einem digitalen Prototypen kombiniert, welcher wiederum rechnergestützt hinsichtlich seiner Baubarkeit überprüft werden kann, um somit festzustellen, ob die an sich voneinander unabhängig entwickelten Bauteile tatsächlich zueinander bzw. in den geplanten Bauraum des Gesamtprodukts passen.

Fahrzeuge werden in der Regel auf Grundlage einer Stückliste, welche sämtliche Teile des entsprechenden Fahrzeugs definiert, entwickelt. Nachdem jedoch die Stückliste eine Vielzahl von unterschiedlichen Varianten bzw. Kombinationen der einzelnen Bauteile des Fahrzeugs zulässt, werden mit herkömmlilchen Analyseverfahren nur ausgewählte Fahrzeugzusammenstellungen hinsichtlich ihrer Baubarkeit überprüft, d.h. es werden auf Grundlage der Stückliste Referenzfahrzeuge zusammengestellt, welche anschließend dahingehend überprüft werden, ob die für diese Referenzfahrzeuge vorgesehenen Bauteile wie gewünscht zusammenpassen. Die Referenzfahrzeuge werden dabei so gewählt, dass die wesentlichen Kombinationen der unterschiedlichen Bauteile der jeweils vorgegebenen Stückliste abgedeckt werden können, wobei im Rahmen des DMU-Prozesses die geometrischen Hüllen der einzelnen Bauteile zueinander analysiert werden.

Bei den herkömmlichen Analyseverfahren wird jedoch die Varianz auf Basis der Stückliste nicht abgebildet, d.h. es können nicht sämtliche möglichen Kombinationen der Bauteile auf Basis der Stückliste hinsichtlich ihrer Baubarkeit überprüft werden. Darüber hinaus ist mit den herkömmlichen Analyseverfahren keine Berechnung freier Bauräume möglich und Bauraumvorhaltungen bleiben unberücksichtigt. Mehrfachkollisionen zwischen unterschiedlichen Bauteilen des Gesamtprodukts können nicht systematisch entdeckt werden.

Der vorliegenden Erfindung liegt daher die Aufgabe zu Grunde, ein Verfahren sowie eine entsprechend ausgestaltete Vorrichtung zur rechnergestützten Überprüfung der Baubarkeit eines Produkts wie beispielsweise eines Kraftfahrzeugs, bereitzustellen, womit die Analyse der Baubarkeit des Produkts verbessert werden kann. Insbesondere liegt der Erfindung die Aufgabe zu Grunde, ein derartiges Verfahren und eine derartige Vorrichtung bereitzustellen, womit eine geometrische Überprüfung der Baubarkeit eines Produkts einschließlich der Varianz auf Grundlage einer vorgegebenen Stückliste möglich ist, wobei auch freie Bauräume oder Mehrfachkollisionen erkennbar sein sollen und die Berücksichtigung von Bauraumvorhaltungen möglich sein soll.

Diese Aufgabe wird erfindungsgemäß durch ein Verfahren zur rechnergestützten Überprüfung der Baubarkeit eines Produkts mit den Merkmalen des Anspruchs 1 bzw. eine entsprechend ausgestaltete Vorrichtung mit den Merkmalen des Anspruchs 13 gelöst. Die abhängigen Ansprüche definieren bevorzugte und vorteilhafte Ausführungsformen der vorliegenden Erfindung.

Erfindungsgemäß wird die Baubarkeit eines Produkts durch Analyse gegenüber einem geometrischen räumlichen Referenzmodell eines Bauraums des Produkts oder auch des Gesamtprodukts analysiert, wobei als geometrisches räumliches Referenzmodell an sich jede beliebige Modellform, wie beispielsweise eine Würfel-, Kugel- oder Pyramidenform, verwendet werden kann, welche in eine Vielzahl von einzeln identifizierbaren räumlichen Einheiten, wie beispielsweise Teilwürfeln oder dergleichen, unterteilt ist. Auch eine Kombination unterschiedlicher geometrischer Formen ist möglich, z.B. wenn nach einem Schwerpunkt eines Bauteils gewichtet wird. Die Überprüfung der Baubarkeit des Produkts erfolgt dann durch einen rechnergestützten Vergleich des jeweils in das Gesamtprodukt einzubauenden Bauteils mit den einzelnen räumlichen Einheiten des Referenzmodells, wobei gemäß einer Ausführungsform der Erfindung der im Rahmen eines CAD-Entwicklungsprozesses erzeugte Datensatz des jeweiligen Bauteils mit Lage- und Beleginformationen des Referenzmodells verglichen wird, wobei die Lage- und Beleginformationen des Referenzmodells angeben, zu welchem Zeitpunkt welche Bauteile welche Einheiten des Referenzmodells belegen, so dass durch einen Vergleich festgestellt werden kann, ob das Bauteil zu einem bestimmten Zeitpunkt mit anderen Bauteilen oder anderen Rahmenbedingungen kollidiert.

Insbesondere ermöglicht die Erfindung eine zeitliche Auflösung der Baubarkeitsanalyse, d.h. ergibt die Überprüfung, dass ein einzubauendes Bauteil mit einem anderen Bauteil oder anderen Rahmenbedingungen kollidiert, kann überprüft werden, ob diese Kollision tatsächlich zu einem bestimmten Zeitpunkt gegeben ist, d.h. es kann überprüft werden, ob kollidierende Bauteile tatsächlich gleichzeitig an derselben Stelle in einzelnen räumlichen Einheiten des Referenzmodells und somit an entsprechenden räumlichen Positionen innerhalb des vorgesehenen Bauraums sein können.

Gemäß einer bevorzugten Ausführungsform wird das erfindungsgemäße Analyseverfahren (vorzugsweise automatisch) immer dann durchgeführt, wenn während der Entwicklung des Gesamtprodukts im Zuge des DMU-Prozesses zu einem Bauteil neue Daten vorliegen und in die digitale Abbildung des Gesamtprodukts eingebunden werden sollen, wobei dieser Vorgang des Einbindens auch als "Einchecken" bezeichnet wird. Dabei kann es sich um Bauteildaten sowohl von neu entwickelten Bauteilen als auch von Altbestand oder von geänderten Bauteilen handeln. Wurde ein Bauteil in die digitale Abbildung des Gesamtprodukts eingecheckt, werden die von diesem Bauteil in dem entsprechenden räumlichen Referenzmodell belegten räumlichen Teileinheiten als belegt markiert, d.h. jedes Bauteil wird in eine entsprechende Lage- und Beleginformation umgesetzt, die in einer Datenbank abgelegt wird. Zur Überprüfung der Baubarkeit des Gesamtprodukts muss somit lediglich überprüft werden, ob ein neu einzucheckendes Bauteil mit als belegt markierten räumlichen Teileinheiten des Referenzmodells kollidiert.

Nachdem gemäß der bevorzugten Ausführungsform der Erfindung die Analyse der Baubarkeit des Gesamtprodukts auf Basis eines Vergleichs mit Beleginformationen der einzelnen räumlichen Einheiten des räumlichen Referenzmodells erfolgt, ist es auch möglich, im Entwicklungsprozess Bauraumvorhaltungen oder Freiräume zu berücksichtigen, indem einfach die entsprechenden räumlichen Einheiten des Referenzmodells als belegt markiert werden.

Die Auflösung des Referenzmodells, d.h. die Anzahl und Größe der einzelnen räumlichen Teileinheiten des in digitaler Form vorliegenden geometrischen räumlichen Referenzmodells, ist an sich lediglich durch die Rechenleistung des zur Durchführung der Erfindung vorgesehenen Rechnersystems beschränkt. Um die Rechenleistung nicht unnötig zu belasten, kann gemäß einer Ausführungsform der Erfindung vorgesehen sein, die Auflösung des Referenzmodells stufenweise zu verfeinern, so dass in einem ersten Analyseschritt lediglich mit einem relativ groben Referenzmodell die Baubarkeit des Gesamtprodukts überprüft wird, während anschließend in Form eines kaskadierenden Prozesses stufenweise die Auflösung erhöht wird, um immer genauere Aussagen über die Baubarkeit des Gesamtprodukts treffen zu können, so dass eindeutige Kollisionen zwischen einzubauenden Bauteilen bereits auf Basis des relativ groben Referenzmodells erkannt werden können, während die höher aufgelösten Referenzmodelle nur zur Anwendung kommen, wenn auch geringere Kollisionsabstände analysiert werden sollen.

Die vorliegende Erfindung kann vorzugsweise im Entwicklungsprozess von Kraftfahrzeugen zur Überprüfung der Baubarkeit eines gesamten Kraftfahrzeugs oder eines Teilbauraums des Kraftfahrzeugs eingesetzt werden, wobei die Erfindung jedoch selbstverständlich nicht darauf beschränkt ist, sondern grundsätzlich auf jedes beliebige Produkt anwendbar ist, welches aus einer Vielzahl von Bauteilen zusammengesetzt ist.

Durch die Verwendung des erfindungsgemäß vorgeschlagenen geometrischen räumlichen Referenzmodells können Mehrfachkollisionen eines Bauteils zuverlässig erkannt werden, da durch die als belegt markierten räumlichen Teileinheiten des Referenzmodells eindeutig die räumliche Lage des jeweiligen Bauteils in dem zu analysierenden Bauraum des Gesamtprodukts definiert ist. Mit Hilfe des Referenzmodells können auch Freigangsuntersuchungen und Unterschreitungen an mehreren Stellen erkannt und benannte werden, wobei es auch möglich ist, im Konstruktionsprozess irrtümlicherweise außerhalb des Gesamtprodukts oder zuvor definierten Zonen liegende Bauteile zu erkennen, wobei diese Situation beispielsweise auftreten kann, wenn ein falsches Bauteil für das Produkt in die digitale Abbildung des Produkts eingecheckt wird.

Nachdem gemäß der bevorzugten Ausführungsform der Erfindung die Analyse der Baubarkeit insbesondere auf Basis der räumlichen Teileinheiten des Referenzmodells erfolgt, kann auch eine Aussage darüber getroffen werden, unter welchen Bedingungen bzw. Attributen ein zu analysierendes Bauteil verbaut werden kann, da die Information über dreidimensional freie Bauräume vorliegt.

Auch wenn die Erfindung hier anhand des bevorzugten Ausführungsbeispiels der Überprüfung der Verbaubarkeit eines Bauteils beschrieben wird, ist die Erfindung nicht auf Bauteile im eigentlichen Sinn beschränkt, sondern kann ganz allgemein auf geometrische Körper angewendet werden. Im Falle einer Fahrzeugkonstruktion kann es sich hier beispielsweise auch um Einfahrhüllen, Bewegungshüllen oder Packagekörper (wie z.B. Getränkedosen, Bücher etc.) handeln, die bei der Fahrzeugkonstruktion zu berücksichtigen sind.

Die Erfindung wird nachfolgend unter Bezugnahme auf die Zeichnung anhand eines bevorzugten Ausführungsbeispiels erläutert.

Fig. 1 zeigt ein Rechnersystem zur rechnergestützten Konstruktion und zur rechnergestützten Überprüfung der Baubarkeit eines Produkts gemäß einem bevorzugten Ausführungsbeispiel der Erfindung, und

Fig. 2 zeigt eine Darstellung eines geometrischen räumlichen Referenzmodells eines zu analysierenden Bauraums des Produkts, welches bei dem in Fig. 1 dargestellten Ausführungsbeispiel zur Anwendung kommt.

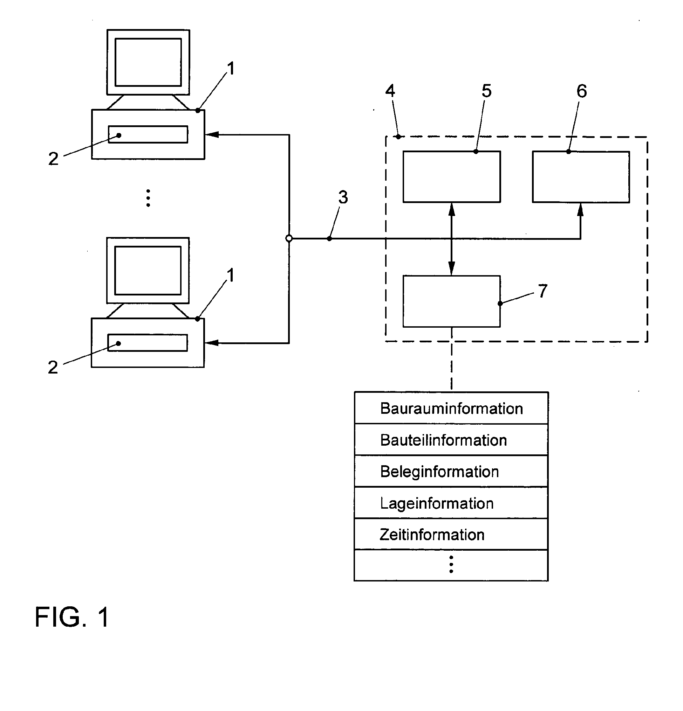

Fig. 1 zeigt eine vereinfachte schematische Darstellung eines Systems zur rechnergestützten Entwicklung bzw. Konstruktion eines Produkts, beispielsweise eines Fahrzeugs, wobei das in Fig. 1 dargestellte System eine rechnergestützte Vorrichtung 4 zur Überprüfung der Baubarkeit dieses Produkts umfasst.

Wie in Fig. 1 dargestellt ist, umfasst das System mehrere Rechnerarbeitsplätze 1, welche bei dem in Fig. 1 dargestellten Ausführungsbeispiel über ein Datenübertragungsnetz 3 mit der Vorrichtung 4 verbunden sind. Bei den Rechnerarbeitsplätzen 1 handelt es sich um CAD-Arbeitsplätze, an denen jeweils einzelne Bauteile des zu konstruierenden Gesamtprodukts entwickelt werden, wobei die daraus resultierenden CAD-Daten der einzelnen Bauteile in Speichern 2 der Rechnerarbeitsplätze 1 abgelegt und darüber hinaus über das Datenübertragungsnetz 3 an die Vorrichtung 4 übertragen werden.

Die Vorrichtung 4 überprüft die Baubarkeit des auf Basis der an den einzelnen Rechnerarbeitsplätzen 1 entwickelten Bauteilen konstruierten Gesamtprodukts unter Anwendung der DMU-Technologie, wobei die Vorrichtung 4 intern mit einem reduzierten Datenformat arbeitet. Aus diesem Grund umfasst die Vorrichtung 4 eine Einrichtung 5, welche die von den einzelnen Rechnerarbeitsplätzen 1 über das Datenübertragungsnetz 3 erhaltenen CAD-Daten beispielsweise durch Triangulierung in ein neutrales, angenähertes tessiliertes Datenformat umsetzt, welches auf das Wesentliche reduziert ist. Somit ist es auch irrelevant, in welchem CAD-Format die einzelnen Bauteile an den einzelnen Rechnerarbeitsplätzen 1 entwickelt worden sind. Die die einzelnen Bauteile beschreibenden Bauteildaten werden in einem Speicher 7 der Vorrichtung 4, bei welcher es sich ebenfalls um einen Rechnerarbeitsplatz handeln kann, gespeichert.

Die Vorrichtung 4 umfasst eine Einrichtung 6, welche durch Zugriff auf die Bauteiledaten und weitere das Gesamtprodukt beschreibende Daten die Baubarkeit des Gesamtprodukts überprüft, wobei es sich bei der Einrichtung 6 insbesondere um eine DMU-Verifizierungseinrichtung handelt, welche vorzugsweise derart ausgestaltet ist, dass sie jedes Mal dann, wenn neue Daten eines Bauteils von den einzelnen Rechnerarbeitsplätzen 1 vorliegen, durch Zugriff auf die im Speicher 7 abgelegten Informationen überprüft, ob das entsprechende Bauteil wie vorgesehen verbaut werden kann oder mit bereits zuvor "eingecheckten" Bauteilen oder anderen Rahmenbedingungen des Gesamtprodukts kollidiert. Die Verifizierung der Baubarkeit des Gesamtprodukts wird dabei vorzugsweise vollautomatisch durchgeführt und abhängig davon eine entsprechende Rückmeldung generiert, welche sowohl an einem Bildschirm der Vorrichtung 4 ausgegeben werden kann als auch in Form einer elektronischen Mitteilung an den entsprechenden Rechnerarbeitsplatz 1, an dem das jeweilige Bauteil konstruiert worden ist, übertragen werden kann.

Die Überprüfung der Baubarkeit des Gesamtprodukts erfolgt in der Einrichtung 6 anhand eines geometrischen räumlichen Referenzmodells, dessen Daten ebenfalls im Speicher 7 abgelegt sind. Dieses geometrische Referenzmodell kann derart sein, dass es das Gesamtprodukt räumlich nachbildet, wobei alternativ jedoch auch möglich ist, dass durch dieses Referenzmodell lediglich ein Teilbauraum des Gesamtprodukts, welcher augenblicklich zu analysieren ist, nachgebildet wird. Das Referenzmodell ist insbesondere derart, dass es in eine Vielzahl von einzeln identifizierbaren räumlichen Einheiten unterteilt ist, wobei die einzelnen räumlichen Einheiten gleich groß sein können, ohne dass die Erfindung jedoch hierauf beschränkt ist.

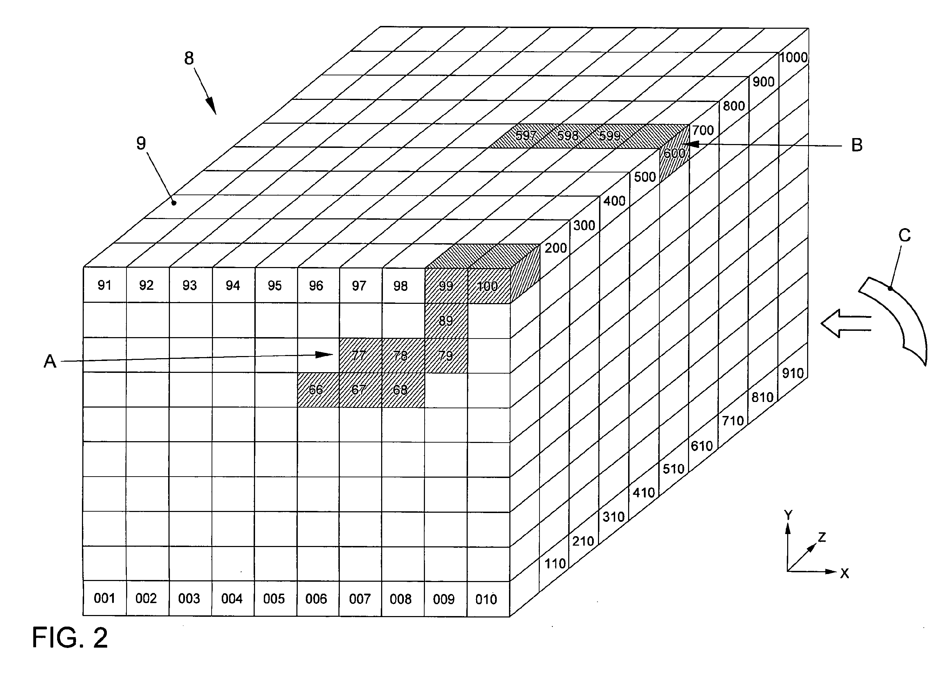

Wie in Fig. 2 gezeigt ist, kann als räumliches Referenzmodell 8 beispielsweise ein Würfelgebilde verwendet werden, welches in eine Vielzahl von räumlichen Teileinheiten 9 unterteilt ist, die ebenfalls eine Würfelform aufweisen. Die Erfindung ist jedoch auf das in Fig. 2 dargestellte bevorzugte Ausführungsbeispiel nicht beschränkt, sondern es kann grundsätzlich jede beliebige räumliche Form, beispielsweise auch eine Pyramiden- oder Kugelform etc., verwendet werden. Ebenfalls ist die Erfindung nicht darauf beschränkt, dass die Raumform der räumlilchen Einheiten 9 der Raumform des Referenzmodells 8 entspricht.

Erhält die Einrichtung 6 neue Baudaten von einem der Rechnerarbeitsplätze 1, wird das entsprechende Bauteil in das in Fig. 2 dargestellte Referenzmodell eingecheckt, d.h. dem Bauteil werden abhängig von seinen Abmessungen und der gewünschten Lage in dem zu überprüfenden Bauraum entsprechende räumliche Einheiten 9 des Referenzmodells 8 zugewiesen, und diese räumlichen Einheiten werden in dem Referenzmodell 8 als belegt markiert. So ist beispielsweise in Fig. 2 bereits ein Bauteil A in das Referenzmodell 8 eingecheckt worden, welches durch die räumlichen Einheiten 66-68, 77-79, 89, 99 und 100 eindeutig identifizierbar ist. Ein weiteres Bauteil B belegt die räumlichen Einheiten 597-600. Die Informationen über die von dem jeweiligen Bauteil belegten räumlichen Einheiten 9 und die Lage in dem Referenzmodell 8 bzw. dem zu überprüfenden Bauraum wird zusammen mit der Information über das jeweilige Bauteil in dem Speicher 7 abgelegt. Darüber hinaus wird auch eine Information darüber abgelegt, wann während eines Betriebs des entsprechenden Produkts die einzelnen räumlichen Einheiten 9 von dem jeweiligen Bauteil belegt werden, was in Fig. 1 als "Zeitinformation" bezeichnet ist.

In dem Speicher 7 befindet sich somit eine Datenbank, in welcher sowohl der zu überprüfende Bauraum als auch die einzelnen Bauteile vollständig beschrieben sind, wobei die Daten über die einzelnen Bauteile auch durch Informationen aus der der Entwicklung des Gesamtprodukts zu Grunde liegenden Stückliste, wie beispielsweise Teilenummer, Material, Informationen über die Beziehung der einzelnen Bauteile zueinander und deren zeitlicher Einsatz etc., ergänzt sein können.

Wird beim Einchecken eines neuen Bauteils, beispielsweise des in Fig. 2 dargestellten Bauteils C, festgestellt, dass die für dieses Bauteil in dem Referenzmodell 8 vorgesehenen räumlichen Einheiten 9 bereits als belegt markiert sind, wird von der Einrichtung 6 durch Zugriff auf die ebenfalls in dem Speicher 7 abgelegte Zeitinformation überprüft, ob tatsächlich das neu einzucheckende Bauteil C und das bereits die entsprechenden räumlichen Einheiten in dem Referenzmodell 8 belegende und damit kollidierende Bauteil in dem überprüften Bauraum gleichzeitig an derselben Stelle sein können. Ist dies nicht der Fall, werden die entsprechenden räumlichen Einheiten 9 mit einer entsprechenden Zeitinformation über die Belegung durch das neu eingecheckte Bauteil C versehen und die entsprechenden Daten in dem Speicher 7 abgelegt, d.h. eine mehrfache Belegung ein und desselben Bauraums bzw. ein und derselben räumlichen Einheit 9 des Referenzmodells 8 ist möglich, sofern ausgeschlossen ist, dass die entsprechenden Bauteile tatsächlich gleichzeitig an derselben Stelle in dem Bauraum auftreten können.

Für den Fall, dass jedoch eine Kollision beim Einchecken des neuen Bauteils C mit bereits belegten räumlichen Einheiten 9 des Referenzmodells 8 festgestellt wird, wird das Einchecken des neuen Bauteils C abgebrochen und eine entsprechende Fehler- bzw. Rückmeldung ausgegeben.

Mit der zuvor beschriebenen Vorgehensweise können auch Merhfachkollisionen eines Bauteils erkannt und benannt werden, wobei darüber hinaus auch möglich ist, Freigangsuntersuchungen und Unterschreitungen an mehreren Stellen zu erkennen. Bauraumvorhaltungen können berücksichtigt werden, wobei hierzu lediglich in dem Referenzmodell 8 die entsprechenden Einheiten 9 mit einem Sperrvermerk versehen werden müssen. Ebenso können von der Vorrichtung 4 automatisch Freiräume für benötigte neue Bauteile ermittelt und einem Benutzer mitgeteilt werden, da - wie in Fig. 2 angedeutet - die Information über die bereits belegten räumlichen Einheiten 9 des Referenzmodells 8 dreidimensional vorliegt.

Zudem können freie Bauräume identifiziert werden, wobei abhängig von dem zu verbauenden Bauteil von dem System automatisch diejenigen freien Bauräume ausgegeben bzw. angezeigt werden, welche zum Verbauen des jeweiligen Bauteils in Frage kommen. Nachdem den einzelnen räumlichen Einheiten des Referenzmodells Informationen über die diese räumlichen Einheiten belegenden Bauteile zusammen mit Informationen darüber, wann und gegebenenfalls unter welchen Bedingungen oder Attributen die räumlichen Einheiten belegt sind, können bei der Suche nach freien Bauräumen automatisch diejenigen räumlichen Einheiten ausgeblendet werden, welche die für ein zu verbauendes Bauteil definierten Vorgaben nicht erfüllen.

Durch Auswertung des zuvor erläuterten Referenzmodells kann schließlich auch festgestellt werden, ob tatsächlich zu allen relevanten Bauteilen ein entsprechendes Datenmodell vorliegt. In der der Konstruktion des Gesamtprodukts zu Grunde liegenden Stückliste ist für jedes Bauteil verzeichnet, ob das entsprechende Bauteil DMU-relevant ist, d.h. ob das jeweilige Bauteil über eine abbildbare geometrische Information verfügt und demzufolge in das Referenzmodell eingecheckt werden sollte. Ist ein Bauteil als "DMU-relevant" verzeichnet und ergibt sich jedoch bei einer Überprüfung des Referenzmodells bzw. der entsprechenden Daten, dass tatsächlich von dem entsprechenden Bauteil in dem Referenzmodell keine einzige räumliche Einheit 9 des jeweiligen Referenzmodells 8 belegt ist, kann darauf geschlossen werden, dass für dieses Bauteil ein Datenmodell fehlt, und es wird eine entsprechende Fehlermeldung generiert.

Die Erfindung kann auch Produkt-übergreifend genutzt werden. Wird beispielsweise ein Bauteil übergreifend in mehreren Fahrzeug-Projekten verbaut, können die Auswirkungen in allen Fahrzeug-Projekten gleichzeitig ermittelt und analysiert werden. Hierzu muss dem Bauteil lediglich eine Information darüber, zu welchen Fahrzeugen es gehört, zugewiesen werden.

Die Funktion der in Fig. 1 gezeigten Verifizierungs- oder Überprüfungseinrichtung 6 erfolgt vorzugsweise softwaregesteuert, wobei die Programmanweisungen des jeweiligen Datenträgers, auf dem die Software gespeichert ist, derart sind, dass bei Ausführungen in einem Computersystem die zuvor beschriebenen Verfahrensschritte vollautomatisch durchgeführt werden.

### BEZUGSZEICHENLISTE

- 1: Rechnerarbeitsplatz
- 2: Speicher
- 3: Netzwerk
- 4: Vorrichtung zur Überprüfung der Baubarkeit
- 5: Triangulierungseinrichtung
- 6: Verifizierungseinrichtung
- 7: Speicher
- 8: Referenzmodell
- 9: Räumliche Teileinheit

## Patentansprüche

1. Verfahren zur rechnergestützten Überprüfung der Baubarkeit eines Produkts, umfassend die Schritte
a) Nachbilden eines Bauraums des Produkts, in dem ein geometrischer Körper (C) zur Konstruktion des Produkts angeordnet werden soll, durch ein digitales räumliches Referenzmodell (8), welches in eine Vielzahl von einzeln identifizierbaren räumlichen Einheiten (9) unterteilt ist,
b) Überprüfen der Baubarkeit des Produkts durch rechnergestütztes Vergleichen des geometrischen Körpers (C) mit den einzelnen räumlichen Einheiten (9) des Referenzmodells (8).

2. Verfahren nach Anspruch 1, **dadurch gekennzeichnet, dass** im Schritt b) das (C) hinsichtlich seiner Lage in dem Bauraum mit dem Referenzmodell derart verglichen wird, dass festgestellt wird, ob die der Lage des geometrischen Körpers in dem Bauraum entsprechenden räumlichen Einheiten (9) des Referenzmodells (8) bereits belegt sind.

3. Verfahren nach Anspruch 2, **dadurch gekennzeichnet, dass** bei Feststellen einer Kollision zwischen der beabsichtigten Lage des geometrischen Körpers (C) in dem Bauraum und mindestens einer dieser Lage entsprechenden Einheit (9) des Referenzmodells (8) überprüft wird, ob der geonmetrische Körper (C) bei Verwendung des Produkts zeitgleich mit einem für die Belegung der entsprechenden räumlichen Einheit (9) des Referenzmodells (8) verantwortlichen weiteren geometrischen Körper (A, B) an einer der räumlichen Einheit (9) entsprechenden Stelle im Bauraum des Produkts auftreten kann.

4. Verfahren nach einem der vorhergehenden Ansprüche, **dadurch gekennzeichnet, dass** für den Fall, dass beim Vergleichen des geometrischen Körpers (C) mit den einzelnen räumlichen Einheiten (8) des Referenzmodells (9) keine Kollision mit als bereits belegt markierten räumlichen Einheiten (8) des Referenzmodells (9) festgestellt wird, die der beabsichtigten Lage in dem Bauraum und den Abmessungen des geometrischen Körpers (C) entsprechenden räumlichen Einheiten (8) des Referenzmodells (9) dem geometrischen Körper (C) zugewiesen und als durch den geometrischen Körper (C) belegt markiert werden.

5. Verfahren nach einem der vorhergehenden Ansprüche, **dadurch gekennzeichnet, dass** das Verfahren durch Zugriff auf Daten, welche den geometrischen Körper (C) definieren, durchgeführt wird, wobei das Verfahren automatisch dann durchgeführt wird, wenn rechnergestützt erzeugte Daten eines neuen geometrischen Körpers (C) vorliegen.

6. Verfahren nach einem der vorhergehenden Ansprüche, **dadurch gekennzeichnet, dass** vor Durchführung des Schritts b) mindestens eine räumliche Einheit (9) des Referenzmodells (8) zur Berücksichtigung von Bauraumvorhaltungen oder Freiräumen als belegt markiert wird.

7. Verfahren nach einem der vorhergehenden Ansprüche, **dadurch gekennzeichnet, dass** der Schritt b) rechnergestützt automatisch durchgeführt wird, um automatisch eine Meldung über die Baubarkeit des Produkts zu erzeugen.

8. Verfahren nach einem der vorhergehenden Ansprüche, **dadurch gekennzeichnet, dass** Daten, welche den geometrischen Körper (C) sowie dessen Lage in dem Bauraum beschreiben, in Form von Informationen über die durch den geometrischen Körper (C) belegten räumlichen Einheiten (9) des Referenzmodells (8) gespeichert werden.

9. Verfahren nach einem der vorhergehenden Ansprüche, **dadurch gekennzeichnet, dass** das Verfahren mehrmals nacheinander mit Referenzmodellen unterschiedlicher Auflösung durchgeführt wird, wobei mit jeder Durchführung des Verfahrens die Auflösung des Referenzmodells erhöht wird.

10. Verfahren nach einem der vorhergehenden Ansprüche, **dadurch gekennzeichnet, dass** das räumliche Referenzmodell (8) eine Würfelform besitzt.

11. Verfahren nach einem der vorhergehenden Ansprüche, **dadurch gekennzeichnet, dass** jede räumliche Einheit (9) des räumlichen Referenzmodells (8) eine Würfelform besitzt.

12. Verfahren nach einem der vorhergehenden Ansprüche, **dadurch gekennzeichnet, dass** das Produkt ein Fahrzeug ist.

13. Verfahren nach einem der vorhergehenden Ansprüche, **dadurch gekennzeichnet, dass** der geometrische Körper ein Bauteil des Produkts ist.

14. Computerprogrammprodukt mit auf einem Datenträger gespeicherten elektronisch lesbaren Steuersignalen, wobei die Steuersignale derart sind, dass bei Verwendung des Computerprogrammprodukts in einem Computersystem (4) das Verfahren nach einem der vorhergehenden Ansprüche ausgeführt wird.

15. Vorrichtung zur rechnergestützten Überprüfung der Baubarkeit eines Produkts, mit Speichermitteln (7), in welchen ein räumliches Referenzmodell (8), welches einen Bauraum des Produkts, in dem ein geometrischer Körper (C) zur Konstruktion des Produkts angeordnet werden soll, nachbildet, wobei das Referenzmodell (8) in eine Vielzahl von einzeln identifizierbaren räumlichen Einheiten (9) unterteilt ist, und mit Auswertungsmitteln (6), welche durch Auswertung des in den Speichermitteln (7) gespeicherten Referenzmodells (8) und durch Vergleichen von Daten, welche den geometrischen Körper (C) beschreiben, mit den einzelnen räumlichen Einheiten (9) des Referenzmodells (8) die Baubarkeit des Produkts überprüfen.

16. Vorrichtung nach Anspruch 15, **dadurch gekennzeichnet, dass** die Vorrichtung zur Durchführung des Verfahrens nach einem der Ansprüche 1-13 ausgestaltet ist.
